# EUROPEAN PATENT SPECIFICATION

(11) **EP 1 451 812 B1**
(45) Date of publication and mention of the grant of the patent: **21.06.2006**
(21) Application number: 02781472.2
(22) Date of filing: 30.10.2002
(51) Int. Cl.: G10L 21/02

(54) **AUDIO SIGNAL BANDWIDTH EXTENSION**
BANDBREITENVERGRÖSSERUNG FÜR AUDIOSIGNALE
EXTENSION DE LARGEUR DE BANDE DE SIGNAL AUDIO

(30) Priority: 23.11.2001 EP 01204498
(43) Date of publication of application: 01.09.2004
(73) Proprietor: Koninklijke Philips Electronics N.V., 5621 BA Eindhoven (NL)
(72) Inventor: SMEETS, Jo, NL-5656 AA Eindhoven (NL); VAN DE PAR, Steven, L., J., D., E., NL-5656 AA Eindhoven (NL)
(74) Representative: Steenbeek, Leonardus Johannes
(86) International application number: PCT/IB2002/004606
(87) International publication number: WO 2003/044777

(56) References cited:
- EP-A- 1 047 045
- WO-A-00/45379
- SCHNITZLER J: "A 13.0 kbit/s wideband speech codec based on SB-ACELP" ACOUSTICS, SPEECH AND SIGNAL PROCESSING, 1998. PROCEEDINGS OF THE 1998 IEEE INTERNATIONAL CONFERENCE ON SEATTLE, WA, USA 12-15 MAY 1998, NEW YORK, NY, USA,IEEE, US, 12 May 1998 (1998-05-12), pages 157-160, XP010279148 ISBN: 0-7803-4428-6
- TAORI R ET AL: "Hi-bin: an alternative approach to wideband speech coding" ICASSP 2000. 2000 IEEE INTERNATIONAL CONFERENCE ON ACOUSTICS, SPEECH AND SIGNAL PROCESSING, 5 - 9 June 2000, XP010504933 ISTANBUL
- MAKHOUL J ET AL: "High-frequency regeneration in speech coding systems" ICASSP 79. 1979 IEEE INTERNATIONAL CONFERENCE ON ACOUSTICS, SPEECH AND SIGNAL PROCESSING, WASHINGTON, DC, USA, 2-4 APRIL 1979, pages 428-431, XP001122019 1979, New York, NY, USA, IEEE, USA

## Description

The invention relates to a bandwidth extender for generating a wideband audio signal from a narrowband audio signal, wherein the bandwidth extender comprises spectral folding means coupled to the input for generating a spectrally folded audio signal by spectrally folding at least part of the narrowband audio signal.

The invention further relates to a receiver for receiving a narrowband audio signal via a transmission channel, the receiver comprising a bandwidth extender for generating a wideband audio signal from a narrowband audio signal, a method of receiving a narrowband audio signal, and a method of generating a wideband audio signal from a narrowband audio signal.

EP-A-1047045 discloses a sound synthesizer. A noise adder generates a noise signal having a frequency band of 3,400 to 4,600 Hz, adjusts the gain of the noise signal, and adds the gain-adjusted noise signal to an excitation source after being filled with zeros by a zero-filling circuit, thereby providing a wide-band excitation source which is rather flat. The signal gain is adjusted by determining a narrow-band excitation source or a power of the wide-band excitation source after being filled with zeros and fining the gain to the narrow-band excitation source or the power.

The paper "Speech Enhancement Via Frequency Bandwidth Extension Using Line Spectral Frequencies" by S. Chennoukh, A. Gerrits, G. Miet and R. Sluijter in the proceedings of the 2001 IEEE International Conference on Acoustics, Speech, and Signal Processing, Salt Lake City, Utah, May 8-11, 2001, describes a bandwidth extender that may, for example, be used for audio signals, e.g. speech signals or music signals, received from a transmission medium such as a radio channel, a coaxial cable or an optical fiber. Other possible applications are automatic answering machines, dictating machines, (mobile) telephones, MP3 players and spoken books.

Narrowband speech, which is used in the existing telephone networks, has a bandwidth of 3100 Hz (300 - 3400 Hz). Speech sounds more natural if the bandwidth is increased to around 7 kHz (50 - 7000 Hz). Speech with this bandwidth is called wideband speech and has an additional low band (50 - 300 Hz) and high band (3400 - 7000 Hz). From the narrowband speech signal, it is possible to generate a high band and a low band by extrapolation. The resulting speech signal is called a pseudo-wideband speech signal. Several techniques for extending the bandwidth of narrowband signal are known, for example from the paper "A new technique for wideband enhancement of coded narrowband speech", IEEE Speech Coding Workshop 1999, June 20-23, 1999, Porvoo, Finland. These techniques are used to improve the speech quality in a narrowband network, such as a telephone network, without changing the network. At the receiving side (e.g. a mobile phone or a telephone answering machine) the narrowband speech can be extended to pseudo-wideband speech. It is a drawback of this known bandwidth extender that the spectral folding of the input narrowband signal introduces harmonic shifts (i.e. the harmonic components in the highband are not exactly located at the frequencies where they should have been located), which harmonic shifts result in a crackling or metallic-like sound when reproduced. These harmonic shifts occur because the harmonic components of the high band are only harmonic related to those of the narrow-band signal when harmonic sampling is used (which in general will not be the case).

It is an object of the invention to provide a bandwidth extender that does not suffer from this drawback. The invention is defined by the independent claims. The dependent claims define advantageous embodiments.

It has been found that the harmonic shifts in the spectrally folded audio signal can effectively be masked by combining the spectrally folded audio signal and the shaped noise signal. As the harmonic shifts are masked the undesired crackling/metallic-like sound is no longer present when the wideband audio signal is reproduced.

The shaped noise signal may be generated by shaping a (white) noise signal in accordance with a property of (at least part of) the spectrally folded audio signal, e.g. in accordance with an amplitude or a phase of the spectrally folded audio signal. The noise signal is shaped in proportion to a temporal envelope of at least part of the spectrally folded audio signal. Listening tests have shown that the combination of such a shaped noise signal and the spectrally folded audio signal results in a very good quality wideband audio signal.

The above object and features of the present invention will be more apparent from the following description of the preferred embodiments with reference to the drawings, wherein:
Fig. 1 shows a block diagram of an embodiment of the transmission system 10 comprising a receiver 14 having a bandwidth extender 18 according to the invention,
Fig. 2 shows a block diagram of an embodiment of a bandwidth extender 18 according to the invention,
Fig. 3 shows a block diagram of an embodiment of a noise shaper 32 for use in the transmission system 10 according to the invention,
Fig. 4 shows a block diagram of an embodiment of an envelope extractor/Hilbert transformer 40 for use in the transmission system 10 according to the invention,
Fig. 5 shows a block diagram of a prior art bandwidth extender 18, and
Fig. 6 shows a block diagram of a part 74 of the bandwidth extender 18 of Fig. 5, which part 74 has been adapted in accordance with the present invention.

In the Figures, identical parts are provided with the same reference numbers.

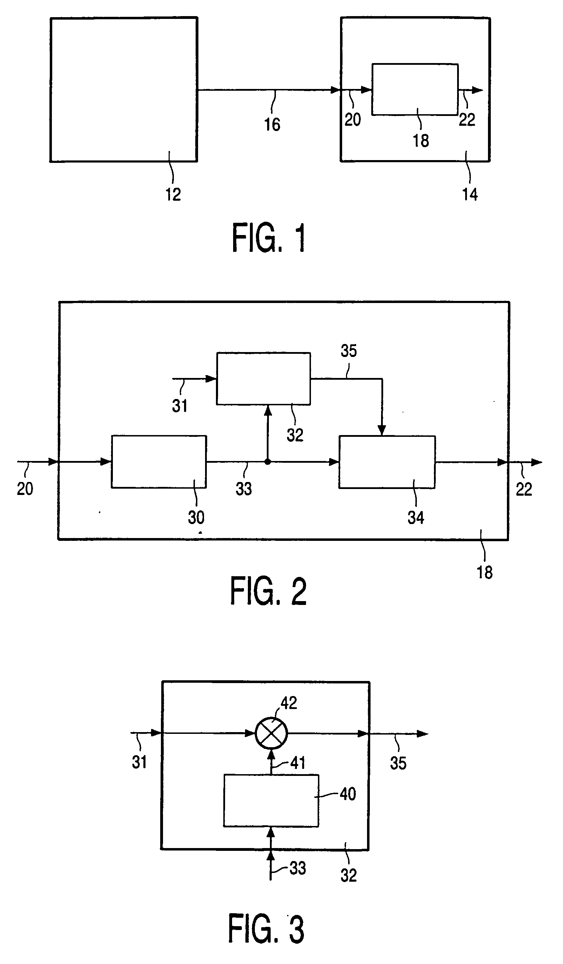

Fig. 1 shows a block diagram of an embodiment of the transmission system 10 according to the invention. The transmission system 10 comprises a transmitter 12 for transmitting a narrowband audio signal, e.g. a narrowband speech signal or a narrowband music signal, to a receiver 14 via a transmission channel 16. The transmission system 10 may be a telephone communication system wherein the transmitter may be a (mobile) telephone and wherein the receiver may be a (mobile) telephone or an answering machine. The receiver 14 comprises a bandwidth extender 18 for generating a wideband audio signal from the narrowband audio signal. The bandwidth of the narrowband audio signal is smaller than the bandwidth of the wideband audio signal. The bandwidth extender 18 comprises an input 20 for receiving the narrowband audio signal and an output 22 for supplying the wideband audio signal to additional signal processing parts (not shown) of the receiver 14, which additional signal processing parts may be arranged for amplification, reproduction and/or storage of the wideband audio signal.

Fig. 2 shows a block diagram of an embodiment of a bandwidth extender 18 according to the invention, which bandwidth extender 18 may be used in the transmission system 10 according to the invention. The bandwidth extender 18 comprises an input 20, spectral folding means 30, a noise shaper 32, a combiner 34 and an output 22. The spectral folding means 30 are coupled to the input 20 so that a narrowband audio signal that is received via the input 20 is supplied to the spectral folding means 30. The spectral folding means 30 are arranged for generating a spectrally folded audio signal 33 by spectrally folding at least part of the narrowband audio signal. The spectrally folded audio signal 33 is supplied by the spectral folding means 30 to the noise shaper 32 and the combiner 34. The noise shaper 32 is arranged for generating a shaped noise signal 35 by shaping a (white) noise signal 31 in accordance with at least part of the spectrally folded audio signal 33. The shaped noise signal 35 is supplied by the noise shaper 32 to the combiner 34. The combiner 34 is arranged for combining the shaped noise signal 35 and the spectrally folded audio signal 33 into a wideband audio signal. The bandwidth of the wideband audio signal is larger than the bandwidth of the narrowband audio signal. Finally, the wideband audio signal is supplied to the output 22.

Preferably, the noise shaper 32 is arranged for generating the shaped noise signal 35 by shaping the noise signal 21 in proportion to an envelope of at least part of the spectrally folded audio signal 33. Such a noise shaper 32 is shown in Fig. 3. Fig. 3 shows a block diagram of an embodiment of the noise shaper 32 for use in the transmission system 10 according to the invention. The noise shaper 32 comprises an envelope extractor 40 and a mixer 42. The envelope extractor 40 is arranged for extracting an envelope signal 41 from the spectrally folded audio signal 33 and for supplying this envelope signal 41 to the mixer 42. The mixer 42 is arranged for generating the shaped noise signal 35 by multiplying the noise signal 31 with the envelope signal 41.

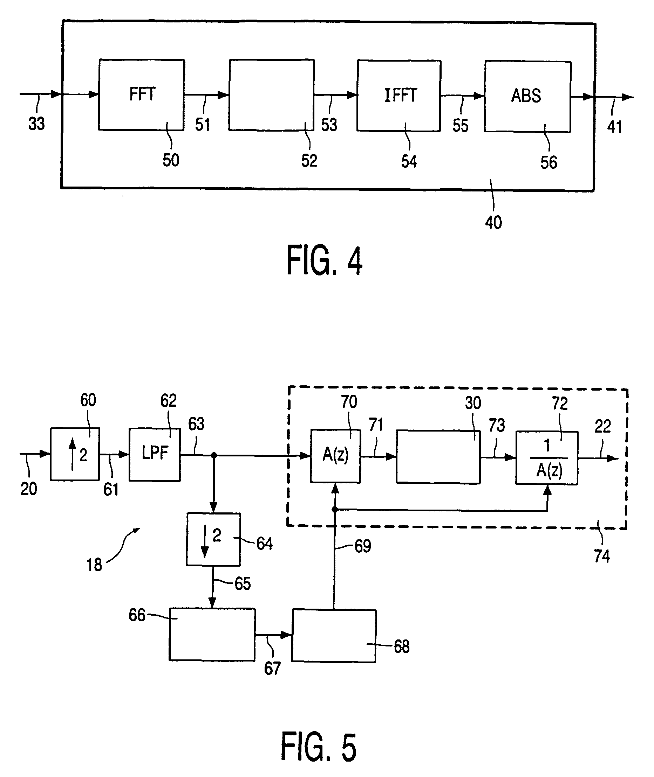

Fig. 4 shows a block diagram of an embodiment of an envelope extractor/Hilbert transformer 40 for use in the receiver 14 according to the invention. The envelope extractor 40 preferably comprises a Hilbert transformer 40. The Hilbert transformer 40 comprises a cascade of a fast Fourier transformer 50, a zeroing unit 52, an inverse fast Fourier transformer 54 and a rectifier 56. The fast Fourier transformer 50 transforms a time domain representation of the spectrally folded signal 33 into a frequency domain representation thereof 51. The zeroing unit 52 is arranged for zeroing the negative frequencies of this frequency domain representation 51. The inverse Fourier transformer 54 is arranged for transforming the zeroed frequency domain representation 53 into a time domain representation thereof 55. The rectifier 56 is arranged for generating the envelope signal 41 by rectifying (i.e. by taking the absolute value of) the zeroed time domain representation 55.

The frequency domain representation 51 of the spectrally folded audio signal 33 is a complex signal. A real signal can be represented by a sum of sinusoids with different phases, amplitudes and frequencies. A fast Fourier transform (FFT) is a sum of complex e-powers. Since a sine can be described as a sum of two e-powers, one with a positive and one with a negative frequency, an FFT-spectrum is symmetrical with respect to zero (DC). By removing the negative frequencies in the zeroing means 52 a spectrum of a complex signal (analytic signal) is created, which is a sum of independent e-powers. When the absolute value is taken of the IFFT of this analytic signal (i.e. by the rectifier 56) the time-domain envelope of the original input signal is found (due to the fact that the absolute value of a complex e-power is equal to one).

Fig. 5 shows a block diagram of a prior art bandwidth extender 18 as known from the paper "Speech Enhancement Via Frequency Bandwidth Extension Using Line Spectral Frequencies" by S. Chennoukh, A. Gerrits, G. Miet and R. Sluijter in the proceedings of the 2001 IEEE International Conference on Acoustics, Speech, and Signal Processing, Salt Lake City, Utah, May 8-11, 2001. An input narrowband speech signal, which is sampled at 8 kHz and which is supplied to the input 20 of the bandwidth extender 18, is first up-sampled by two (i.e. zeros are inserted between successive samples) by an up-sampler 60. The obtained upsampled signal 61 is sampled at 16 kHz. It has the same spectrum in the lowband, i.e. 0-4 kHz, as the input signal and a folded version of it in the highband, i.e. 4-8 kHz. This signal 61 is then low-pass filtered in a low-pass filter 62 to remove the folded version in order to recover the same spectral properties as the input signal but sampled at 16 kHz. The low-pass filtered signal 63 is supplied to an LPC analysis filter 70 and to a down-sampler 64.

The low-pass filtered signal 63 is down-sampled by two by the down sampler 64. Then, the resulting down-sampled signal 65 (which is sampled at 8 kHz) is modeled using an auto-regressive LPC model by means of a LPC analysis filter 66. The LPC analysis filter 66 derives LPC coefficients 67 from the down-sampled signal 65. These LPC coefficients 67 represent the spectrum of the input narrowband speech signal. Next, the narrowband LPC coefficients 67 are used by an envelope extender 68 to extend the spectral envelope of the narrowband signal and to derive wideband LPC coefficients 69. This extension of the spectral envelope is performed by mapping lowband line spectral frequencies (LSFs) to wideband LSFs. This mapping is performed by means of a set of mapping matrices.

Then, the output signal 63 of the low-pass filter 62 is analyzed using an extended LPC analysis filter 70 on basis of the wideband LPC coefficients 69. The analysis residual 71, that is expected to have a flat spectrum is thereafter successively down-sampled and up-sampled by two (i.e. put to zero every other sample) in spectral folding means 30. The successive down- and up-sampling realizes a spectral folding. The resulting spectrally folded signal 73 is a sparse signal that is used to excite a wideband synthesis filter 72 in order to obtain a wideband speech signal that is supplied to the output 22 of the bandwidth extender 18. The wideband synthesis filter 72 operates on basis of the wideband LPC coefficients 69 and is the inverse of the analysis filter 70.

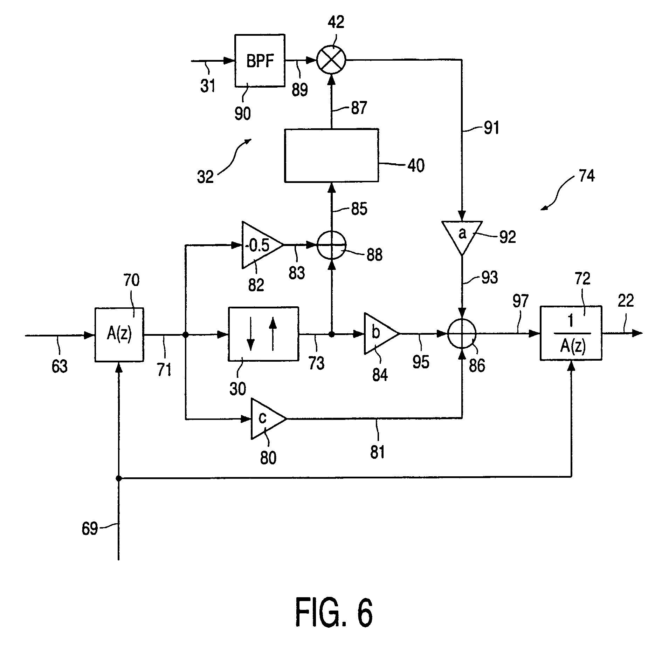

Fig. 6 shows a block diagram of a part 74 of the bandwidth extender 18 of Fig. 5, which part 74 has been adapted in accordance with the principles of the present invention. In addition to the part 74 as shown in Fig. 5 the part 74 as shown in Fig. 6 comprises a noise shaper 32, combiners 86 and 88 and several gain stages 80, 82, 84 and 92. The noise shaper 32 comprises an envelope extractor 40, a mixer 42 and a band-pass filter 90. The combiner 86 is equivalent to the combiner 34 in Fig. 2.

The part 74 of the bandwidth extender 18 as shown in Fig. 5 can be described by the part 74 as shown in Fig. 6 if gain factor a of the gain stage 92 is set to 0 and gain factor *b* of gain stage 84 is set to 2 and gain factor *c* of the gain stage 80 is set to 0. Please note that the gain stage 84 is not shown in Fig. 5.

The spectrally folded signal 73 comprises both lowband and highband signal components. As only the highband part of the spectrally folded signal 73 suffers from harmonic shifts it is not necessary to extract the envelope of the lowband part. Consequently, the lowband signal components are removed from the spectrally folded signal 73 by means of the gain stage 82 and the combiner 88. The amplitude of the spectrally folded signal 73 is equal to half the amplitude of the analysis residual signal 71 (due to the properties of the spectral folder 30 which comprises a cascade of a down-sampler by two and an up-sampler by two). By means of the gain stage 82 the analysis residual signal 71 is attenuated and inverted by the gain stage 82 which applies a gain factor of -0.5 to the analysis residual signal 71. The resulting attenuated analysis residual signal 73 is thereafter added to the spectrally folded signal 73 by means of the combiner 88, thus removing the lowband signal part from the spectrally folded signal 73. The resulting combined signal 85 only comprises highband signal components and is supplied to the envelope extractor 40 (similar to the signal 33 in Fig. 3).

The envelope extractor 40 extracts an envelope signal 87 from the signal 85 and supplies this signal 87 to the mixer 42. The mixer 42 generates a shaped noise signal 91 (similar to signal 35 in Fig. 3) by multiplying a band-pass filtered noise signal 89 with the envelope signal 87. The band-pass filtered noise signal 89 is obtained by filtering a (white) noise signal 31 by means of a band-pass filter 90 which only passes the highband components of the noise signal 31.

The shaped noise signal 91 is amplified/attenuated by the gain stage 92 and the resulting signal 93 is supplied to the combiner 86. The spectrally folded signal 73 is amplified/attenuated by the gain stage 84 and the resulting signal 95 is also supplied to the combiner 86. In addition, the analysis residual signal 71 is amplified/attenuated by the gain stage 80 and the resulting signal 81 is also supplied to the combiner 86. The combiner 86 combines the signals 93, 95 and 81 by adding them into a combined signal 97 which is supplied to the wideband synthesis filter 72.

In order for the wideband synthesis filter 72 to be able to reconstruct the lowband the following relation between the gain factors *b* and c must be valid: 0.5*b* + c = 1. (These low-band signals are 100% correlated, thus amplitudes may be summed.) For the highband the following relation between the gain factors *a* and *b* must be complied with: (*a*/2)² + (*b*/2)² = 1 and hence *a*² + *b*²= 4. (This is because here the signals are not correlated and thus we have to sum energies.) When e.g. *a* = *b* =√2 then c = 1 - ½√2 ≈0.3. However, tuning can provide other combinations that give better results than the computed ones. Satisfactory results where obtained with the following setting: *a* = 1.2, *b* = 1.1 and c = 0.45.

The bandwidth extender 18 may be implemented by means of digital hardware or by means of software which is executed by a digital signal processor or by a general purpose microprocessor.

The scope of the invention is not limited to the embodiments explicitly disclosed. The invention is defined by the claims. Any reference signs do not limit the scope of the claims. The word "comprising" does not exclude the presence of other elements or steps than those listed in a claim. Use of the word "a" or "an" preceding an element does not exclude the presence of a plurality of such elements. The invention can be implemented by means of hardware comprising several distinct elements, and by means of a suitably programmed computer. In the device claim enumerating several means, several of these means can be embodied by one and the same item of hardware.

## Claims

1. A bandwidth extender (18) for generating a wideband audio signal from a narrowband audio signal, the bandwidth extender comprising:
an input (20) for receiving the narrowband audio signal having a first bandwidth;
an output (22) for supplying the wideband audio signal having a second bandwidth that is larger than the first bandwidth;
spectral folding means (30) coupled to the input (20) for generating a spectrally folded audio signal (33) by spectrally folding at least part of the narrowband audio signal; **characterized by**:
a noise shaper (32) for generating a shaped noise signal (35) by shaping a noise signal (31) in proportion to a temporal envelope of at least part of the spectrally folded audio signal (33); and
a combiner (34) for combining the shaped noise signal (35) and the spectrally folded audio signal (33) into the wideband audio signal, thereby masking harmonic shifts in the spectrally folded audio signal (33).

2. The bandwidth extender (18) according to claim 1, **characterized in that** the noise shaper (32) comprises
an envelope extractor (40) for extracting a temporal envelope signal (41) from the spectrally folded audio signal (33), and
a mixer (42) for generating the shaped noise signal (35) by mixing the noise signal (31) with the temporal envelope signal (41).

3. The bandwidth extender (18) according to claim 2, **characterized in that** the envelope extractor (40) comprises a Hilbert transformer that comprises a cascade of a Fourier transformer (50) for transforming a time domain representation of the spectrally folded audio signal (33) into a frequency domain representation thereof (51), means (52) for zeroing the negative frequencies of the frequency domain representation (51), an inverse Fourier transformer (54) for transforming the zeroed frequency domain representation (53) into a time domain representation thereof (55), and a rectifier (56) for generating the temporal envelope signal (41) by rectifying the zeroed time domain representation (55).

4. A receiver (14) for receiving a narrowband audio signal from a transmission channel (16), wherein the receiver (14) comprises a bandwidth extender (18) as claimed in claim 1.

5. A method of generating a wideband audio signal from a narrowband audio signal, wherein the narrowband audio signal has a first bandwidth and the wideband audio signal has a second bandwidth that is larger than the first bandwidth, the method comprising:
generating a spectrally folded audio signal (33) by spectrally folding at least part of the narrowband audio signal, **characterized in that** the method further comprises:
generating a shaped noise signal (35) by shaping a noise signal (31) in proportion to a temporal envelope of at least part of the spectrally folded audio signal (33),
combining the shaped noise signal (35) and the spectrally folded audio signal (33) into the wideband audio signal, thereby masking harmonic shifts in the spectrally folded audio signal (33).

6. The method according to claim 5, **characterized in that** the method further comprises:
extracting a temporal envelope signal (41) from the spectrally folded audio signal (33), and
generating the shaped noise signal (35) by mixing the noise signal (31) with the temporal envelope signal (41).

7. The method according to claim 6, wherein the extracting step comprises:
transforming a time domain representation of the spectrally folded audio signal (33) into a frequency domain representation thereof (51),
zeroing the negative frequencies of the frequency domain representation (51),
transforming the zeroed frequency domain representation (53) into a time domain representation thereof (55), and
generating the temporal envelope signal (41) by rectifying the zeroed time domain representation (55).

## Patentansprüche

1. Bandbreitenerweiterungsanordnung (18) zum Erzeugen eines Breitband-Audiosignals aus einem Schmalband-Audiosignal, wobei die Bandbreitenerweiterungsanordnung Folgendes umfasst:
- einen Eingang (20) zum Empfangen des Schmalband-Audiosignals mit einer ersten bandbreite,
- einen Ausgang (22) zum Liefern des Breitband-Audiosignals mit einer zweiten bandbreite, die größer ist als die erste Bandbrite,
- spektrale Faltungsmittel (30), die mit dem Eingang (20) gekoppelt sind zum Erzeugen eines spektral gefalteten Audiosignals (33) durch spektrale Faltung wenigstens eines Teils des Schmalband-Audiosignals, **gekennzeichnet durch**:
- einen Rauschsignalformer (32) zum Erzeugen eines geformten Rauschsignals (35) **dadurch**, dass einem Rauschsignal (31) Form gegeben wird, und zwar im Verhältnis zu einer zeitlichen Umhüllenden wenigstens eines Teils des spektral gefalteten Audiosignals (33); und
- eine Kombinierschaltung (34) zum Kombinieren des geformten Rauschsignals (35) und des spektral gefalteten Audiosignals (33) zu dem Breitband-Audiosignal, wobei harmonische Verschiebungen in dem spektral gefalteten Audiosignal (33) maskiert werden.

2. Bandbreitenerweiterungsanordnung (18) nach Anspruch 1, **dadurch gekennzeichnet, dass** der Rauschsignalformer (32) Folgendes umfasst:
- eine Umhüllende-Extraktionsstufe (40) zum Extrahieren eines zeitlichen umhüllenden Signals (41) aus dem spektral gefalteten Audiosignal (33), und
- eine Mischstufe (42) zum Erzeugen des geformten Rauschsignals (35) durch Mischung des Rauschsignals (31) mit dem zeitlichen umhüllenden Signals (41).

3. Bandbreitenerweiterungsanordnung (18) nach Anspruch 2, **dadurch gekennzeichnet, dass** die Umhüllende-Extraktionsstufe (40) einen Hilbert-Transformator aufweist, der eine Kaskadenschaltung aus einem Fourier-Transformator (50) zum Transformieren einer Zeitdomänendarstellung des spektral gefalteten Audiosignals (33) zu einer Frequenzdomänendarstellung (51) davon, Mitteln (52) zum Nullen der negativen Frequenzen der Frequenzdomänendarstellung (51), einem invertierten Fourier-Transformator (54) zum Transformieren der genullten Frequenzdomänendarstellung (53) zu einer Zeitdomänendarstellung davon (55), und einem Gleichrichter (56) zum Erzeugen des zeitlichen umhüllenden Signals (41) durch Gleichrichtung der genullten Zeitdomänendarstellung (55).

4. Empfänger (14 zum Empfangen eines Schmalband-Audiosignals von einem Übertragungskanal (16), wobei der Empfänger (14) eine Bandbreitenerweiterungsanordnung (18) nach Anspruch 1 aufweist.

5. Verfahren zum Erzeugen eines Breitband-Audiosignals aus einem Schmalband-Audiosignal, wobei das Schmalband-Audiosignal eine erste Bandbreite hat und das Breitband-Audiosignal eine zweite Bandbreite hat, die größer ist als die erste Bandbreite, wobei das Verfahren Folgendes umfasst:
- das Erzeugen eines spektral gefalteten Audiosignals (33) durch spektrale Faltung wenigstens eines Teils des Schmalband-Audiosignals, **dadurch gekennzeichnet, dass** das Verfahren weiterhin Folgendes umfasst:
- das Erzeugen eines geformten Rauschsignals (35) durch Formung eines Rauschsignals (31) im Verhältnis zu einer zeitlichen Umhüllenden wenigstens eines Teils des spektral gefalteten Audiosignals (33),
- das Kombinieren des geformten Rauschsignals (35) und des spektral gefalteten Audiosignals (33) zu dem Breitband-Audiosignal, wobei harmonische Verschiebungen in dem spektral gefalteten Audiosignal (33) maskiert werden.

6. Verfahren nach Anspruch 5, **dadurch gekennzeichnet, dass** das Verfahren weiterhin Folgendes umfasst:
- das Extrahieren eines zeitlichen umhüllenden Signals (41) aus dem spektral gefalteten Audiosignal (33) und
- das Erzeugen des geformten Rauschsignals (35) durch Mischung des Rauschsignals (31) mit dem zeitlichen umhüllenden Signal (41).

7. Verfahren nach Anspruch 6, wobei der Extraktionsschritt Folgendes umfasst:
- das Transformieren einer Zeitdomänendarstellung des spektral gefalteten Audiosignals (33) zu einer Frequenzdomänendarstellung davon (51),
- dass Nullen der negativen Frequenzen der Frequenzdomänendarstellung (51),
- das Transformieren der genullten Frequenzdomänendarstellung (53) zu einer Zeitdomänendarstellung davon (55), und
- das Erzeugen des zeitlichen umhüllenden Signals (41) durch Gleichrichtung der genullten Zeitdomänendarstellung (55).

## Revendications

1. Dispositif d'extension de largeur de bande (18) pour générer un signal audio en large bande à partir d'un signal audio en bande étroite, le dispositif d'extension de largeur de bande comprenant :
une entrée (20) pour recevoir le signal audio en bande étroite présentant une première largeur de bande;
une sortie (22) pour fournir le signal audio en large bande présentant une seconde largeur de bande qui est plus grande que la première largeur de bande;
un moyen de repliement spectral (30) relié à l'entrée (20) pour générer un signal audio à repliement spectral (33) en repliant le spectre d'au moins une partie du signal audio en bande étroite, **caractérisé par** :
un conformateur de bruit (32) pour générer un signal de bruit conformé (35) en conformant un signal de bruit (31) en proportion à une enveloppe temporelle d'au moins une partie du signal audio à repliement spectral (33), et
un combineur (34) pour combiner le signal de bruit conformé (35) et le signal audio à repliement spectral (33) en signal audio en large bande, de manière à masquer les déplacements harmoniques dans le signal audio à repliement spectral (33).

2. Dispositif d'extension de largeur de bande (18) suivant la revendication 1, **caractérisé en ce que** le conformateur de bruit (32) comprend
un extracteur d'enveloppe (40) pour extraire un signal d'enveloppe temporelle (41) du signal audio à repliement spectral (33), et
un mélangeur (42) pour générer le signal de bruit conformé (35) en mélangeant le signal de bruit (31) avec le signal d'enveloppe temporelle (41).

3. Dispositif d'extension de largeur de bande (18) suivant la revendication 2, **caractérisé en ce que** l'extracteur d'enveloppe (40) comprend un transformateur de Hilbert qui comprend une cascade d'un transformateur de Fourier (50) pour transformer une représentation de domaine de temps du signal audio à repliement spectral (33) en une représentation de domaine de fréquence (51) de ce signal, d'un moyen (52) pour mettre à zéro les fréquences négatives de la représentation de domaine de fréquence (51), d'un transformateur de Fourier inverse (54) pour transformer la représentation de domaine de fréquence mise à zéro (53) en une représentation de domaine de temps (55) de ce signal, et d'un redresseur (56) pour générer le signal d'enveloppe temporelle (41) en redressant la représentation de domaine de temps (55).

4. Récepteur (14) destiné à recevoir un signal audio en bande étroite à partir d'un canal de transmission (16), dans lequel le récepteur (14) comprend un dispositif d'extension de largeur de bande (18) suivant la revendication 1.

5. Procédé pour générer un signal audio en large bande à partir d'un signal audio en bande étroite, dans lequel le signal audio en bande étroite présente une première largeur de bande et le signal audio en large bande présente une seconde largeur de bande qui est plus grande que la première largeur de bande, le procédé comprenant :
la génération d'un signal audio à repliement spectral (33) en repliant le spectre d'au moins une partie du signal audio en bande étroite, **caractérisé en ce que** le procédé comprend en outre :
la génération d'un signal de bruit conformé (35) en conformant un signal de bruit (31) en proportion à une enveloppe temporelle d'au moins une partie du signal audio à repliement spectral (33)
la combinaison du signal de bruit conformé (35) et du signal audio à repliement spectral (33) en signal audio à large bande, masquant ainsi des déplacements harmoniques dans le signal audio à repliement spectral (33).

6. Procédé suivant la revendication 5, **caractérisé en ce que** le procédé comprend en outre :
l'extraction d'un signal d'enveloppe temporelle (41) du signal audio à repliement spectral (33), et
la génération du signal de bruit conformé (35) en mélangeant le signal de bruit (31) avec le signal d'enveloppe temporelle (41).

7. Procédé suivant la revendication 6, dans lequel l'étape d'extraction comprend:
la transformation d'une représentation de domaine temporel du signal audio à repliement du spectre (33) en une représentation de domaine de fréquences de ce signal (51),
la mise à zéro des fréquences négatives de la représentation de domaine de fréquences,
la transformation de la représentation de domaine de fréquence mise à zéro (53) en une représentation de domaine de temps (55), et
la génération du signal d'enveloppe temporelle (41) en redressant la représentation de domaine de temps mis à zéro (55).
